# EUROPEAN PATENT SPECIFICATION

(11) **EP 0 469 204 B1**
(45) Date of publication and mention of the grant of the patent: **15.01.1997**
(21) Application number: 90308570.2
(22) Date of filing: 03.08.1990
(51) Int. Cl.: C23C 16/26, C23C 28/00

(54) **Method for vapour deposition of diamond film**
Verfahren zur Abscheidung aus der Gasphase eines Diamantfilmes
Méthode pour déposer en phase vapeur un film de diamant

(43) Date of publication of application: 05.02.1992
(60) Divisional application: 96100465.2
(73) Proprietor: FUJITSU LIMITED, Kawasaki-shi, Kanagawa 211 (JP)
(72) Inventor: Kawarada, Motonobu, Sagamihara-shi, Kanagawa 228 (JP); Kurihara, Kazuaki, Atsugi-shi, Kanagawa 243-02 (JP); Sasaki, Ken-ichi, Atsugi-shi, Kanagawa 243 (JP); Teshima, Akimoto, Isehara-shi, Kanagawa 259-11 (JP); Koshino, Nagaaki, Yokohama-shi, Kanagawa 241 (JP)
(74) Representative: Silverman, Warren

(56) References cited:
- EP-A- 0 286 306
- EP-A- 0 327 110
- EP-A- 0 379 994
- PATENT ABSTRACTS OF JAPAN, vol. 14, no. 171 (C-706)[4114], 3rd April 1990; & JP-A-2 22 471 (FUJITSU LTD) 25-01-1990
- PATENT ABSTRACTS OF JAPAN, vol. 13, no. 69 (C-569)[3417], 16th February 1989;
- PATENT ABSTRACTS OF JAPAN, vol. 14, no. 118 (C-697)[4061], 6th March 1990; & JP-A-1 317 197 (KANEGAFUCHI CHEM. IND. CO., LTD) 21-12- 1989
- PATENT ABSTRACTS OF JAPAN, vol. 14, no. 397, 28th August 1990; & JP-A-02 149 412 (NAMIKI PRECISION JEWEL CO., LTD) 08-06- 1990

## Description

The present invention relates to a method and apparatus for vapor deposition of diamond film. More specifically, it relates to a highly efficient method and apparatus for uniformly vapor depositing a diamond film having superior adhesiveness to a treated object or substrate.

Diamond is an allotrope of carbon (C), exhibits a diamond structure, has a high Mohs hardness of 10, and has a superior thermal conductivity of 1000 or 2000 W/mK, compared with other materials. Therefore, various applications have been developed using these characteristics.

For example, it has been considered to use it for drill blades or bits by utilizing its high hardness. Attempts have been made to cover such tools, which are made of high hardness sintered alloys such as tungsten carbide (WC), with a diamond film. Further, diamond is utilized as a heat sink of an LSI, VLSI, or laser diode or other semiconductor device using the high heat conductivity thereof.

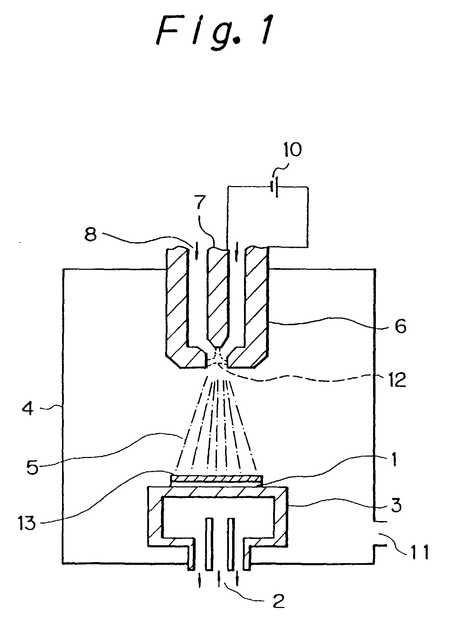

When coating a diamond film on a tool made of tungsten carbide (WC) or molybdenum carbide (MoC), even if a chemical vapor deposition apparatus (abbreviated as a "CVD" apparatus) is used similar to that as shown in Fig. 1 of the accompanying drawings and the film is grown directly by chemical vapor deposition (abbreviated as "CVD"), the film easily peels off due to the difference in the coefficient of heat expansion.

The operation of the above-mentioned known apparatus is as follows.

An object (for example, a tool) to be treated or substrate is placed on a substrate holder 3 cooled by cooling water 2. At the top of the reaction chamber 4 is an anode 6 and a cathode 7 for forming a plasma jet 5. A starting gas 8 is supplied between the anode and the cathode. A DC power source 10 is provided connecting the anode 6 and the cathode 7. At the bottom of the reaction chamber 4 is an exhaust outlet 11. For the CVD growth of diamond, a mixed gas of hydrogen (H₂) and a hydrocarbon, for example, methane (CH₄) is supplied from between the anode 6 and cathode 7 to the inside of the reaction chamber 4. The exhaust system is operated for exhaust from the exhaust outlet 11 and the inside of the reaction chamber 4 is held at a low vacuum, in which state an arc discharge 12 is caused between the anode 6 and cathode 7, the heat of which causes decomposition and plasmatization of the starting gas 8, whereupon the plasma jet 5 including carbon plasma strikes the metal plate 1 and a diamond film 13 composed of fine crystals is grown on the metal plate 1. Thus, it becomes possible to grow a diamond film 13 on the treated object 1, but since the coefficients of heat expansion differ (for example, the linear expansion coefficient of diamond is 0.0132 x 10⁻⁴K⁻¹, while that of W is 0.045 x 10⁻⁴K⁻¹) and since the temperature is decreased from the high temperature of 800°C or more at which the CVD reaction is performed to ordinary temperature, the diamond film 13 easily peels off from the treated object 1.

Therefore, in the past prior art, when coating a diamond film on a tool made of WC, for example, elements (for example, Co) included in the WC as sintering reinforcements and causing a reduction of the adhesiveness were chemically removed, then the CVD method was used to grow the diamond film or mechanical scratches were made and the growth performed over the same. However, since the adhesiveness falls along with the film thickness, the limit of the thickness of the film grown was only several or some µm and even so the adhesiveness was insufficient for practical use. The inventors previously proposed, as a method for resolving this problem, the provision of a coating material layer 15 with a coefficient of heat expansion close to diamond on the treated object 1, as shown in Fig. 2, and the growth of a diamond film 13 on the same (Japanese Unexamined Patent Publication (Kokai) No. 1-145313 published June 7, 1989). However, when actually used, the adhesiveness provided is not still satisfactory for tool use.

As mentioned above, diamond has the highest hardness among all materials, so attempts have been made to use it to form drill blades and bits. However, when diamond is coated on a tool made of, for example, WC, it easily peels off since the heat expansion coefficients differ and therefore this has not been commercialized.

It is an object of the present invention to eliminate the above-mentioned disadvantages of the prior art and to provide a method and apparatus for the vapor deposition of diamond film on an object to be treated and having a superior adhesiveness with the treated object.

JP-A-02 022 471 discloses a method of coating a cemented carbide (such as WC) with a diamond film using a plasma jet CVD apparatus which incorporates a powder feed. In accordance with this disclosure, an intermediate layer is provided between the cemented carbide and the diamond film. The intermediate layer may comprise a first phase formed of a compound forming the hard matrix of the cemented carbide (such as WC) and a second phase formed of said compound and diamond.

According to the present invention, there is provided a method of producing a diamond film on an object to be treated or a substrate by a chemical vapor deposition method comprising the steps of: (i) forming a first intermediate layer, on the object or substrate to be treated, composed of a mixture of a main component element of the object and a component element of a sintering reinforcement agent for diamond selected from the group consisting of cobalt, iron and nickel; (ii) forming a second intermediate layer, on the first intermediate layer, composed of a mixture of the component element of the sintering reinforcement agent for diamond and diamond; and (iii) forming a diamond film on the second intermediate layer, all in the same apparatus, which comprises: (a) an electrode forming member having a first polarity comprising an enclosed body having a nozzle for jetting thermal plasma opened therein and a discharge gas feed pipe; (b) an electrode forming member having an opposite polarity and positioned to be opposed to said nozzle internally of said enclosed body; (c) a direct current plasma torch having a power source supply system containing a direct current source for applying a direct current voltage between said electrode of the first polarity and said electrode of the opposite polarity, which feeds a gas through said discharge gas feed pipe between the electrodes to which the direct current voltage is applied, forming said gas into a thermal plasma by the direct current arc discharge between the electrodes and jetting the thermal plasma formed as a plasma jet through said nozzle; (d) a starting gas feeding system for feeding gaseous starting compounds for vapor phase deposition to said plasma jet; (e) a powder supplying pipe for feeding a metal powder to said arc discharge portion; and (f) a supporting mechanism for supporting the object or substrate in the above non-equilibrium plasma and permitting a thermal plasma chemical vapor deposition film to be deposited in a vapor phase on said object or substrate.

In an embodiment of the present invention, there is provided a method of producing a diamond film on an object to be treated or substrate by a chemical vapor deposition method comprising the steps of:
forming at least two intermediate layers on the object by feeding at least two component elements each in the form of a powder to a plasma jet of a gas generated by a direct current arc discharge, said at least two intermediate layers being composed of (i) a mixture of a main component element of the object or substrate and a component element of a sintering reinforcement agent for diamond selected from the group consisting of cobalt, iron and nickel and (ii) a mixture of the component element of the sintering reinforcement agent for diamond and diamond; and
forming a diamond film thereon by feeding a starting gas containing hydrogen and a carbon source between an anode and a cathode of a thermal plasma chemical vapor deposition device to generate a plasma jet including a radicalized carbon compound, wherein:
during the formation of the intermediate layers and the diamond film, the object or substrate is rotated and is inclined from the flow direction line of the plasma jet by 30 to 60 degree, whereby a diamond film is firmly deposited on the side faces of the object or substrate.

For a better understanding of the invention and to show how the same may be carried into effect, reference will now be made by way of example only, to the accompanying drawings, in which:
Figure 1 illustrates the principle of the known apparatus for use in the formation of a diamond film on a. substrate;
Fig. 2 illustrates the principle of the present invention for use in the formation of a diamond film on an object or substrate;
Fig. 3 is a sectional view for explaining the present invention;
Fig. 4 is an X-ray diffraction pattern of a second intermediate layer;
Fig. 5 is an apparatus for coating a diamond film according to the present invention;
Fig. 6 is a cross-sectional view of the end portion of a substrate coated according to a prior art method; and
Fig. 7 is a cross-sectional view of the end portion of a substrate coated according to the present invention.

In accordance with the present invention, as a method for raising the adhesiveness between the treated object or substrate and the diamond film formed by using the CVD apparatus, two or more intermediate layers are provided on the treated object or substrate, e.g., a first intermediate layer/second intermediate layer/diamond film (or a first intermediate layer/a second intermediate layer/a third intermediate layer/diamond film).

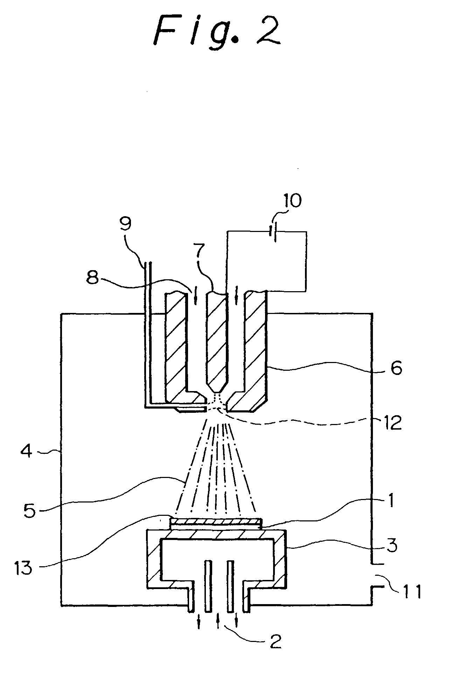

The operation of the apparatus used will now be briefly explained with reference to Fig 2.

An object (for example, a tool) to be treated or substrate is placed on a holder 3 cooled by cooling water 2. At the top of the reaction chamber 4 is an anode 6 and a cathode 7 for forming a plasma jet 5. A starting gas 8 is supplied between the anode and the cathode. To enable formation of a metal layer, a powder feed pipe 9 opens at the tip of the anode 6. A DC power source 10 is provided connecting the anode 6 and the cathode 7. At the bottom of the reaction chamber 4 is an exhaust outlet 11. For the CVD growth of diamond, a mixed gas of hydrogen (H₂) and a hydrocarbon, for example, methane (CH₄) is supplied from between the anode 6 and cathode 7 to the inside of the reaction chamber 4. The exhaust system is operated for exhaust from the exhaust outlet 11 and the inside of the reaction chamber 4 is held at a low vacuum, in which state an arc discharge 12 is caused between the anode 6 and cathode 7, the heat of which causes decomposition and plasmatization of the starting gas 8, whereupon the plasma jet 5 including carbon plasma strikes the metal plate 1 and a diamond film 13 composed of fine crystals is grown on the metal plate 1. According to the present invention to grow a mixed film of metal and diamond, a metal powder is supplied through the powder feed pipe 9 into the arc discharge 12, and to grow just a metal film, H₂ is used as the starting gas 8 and metal powder or inorganic material powder (e.g., silicon) is supplied through the powder feed pipe 9 into the arc discharge 12.

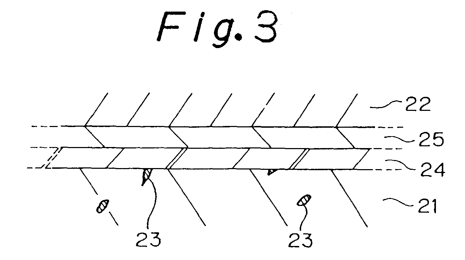

Figure 3 is a sectional view for explaining the present invention. In Fig. 3, the treated object 21 is a sintered body comprising WC or Mo₂C, in which sintered body is dispersed a sintering reinforcement 23 such as cobalt (Co). The present invention has a first intermediate layer 24 composed of a mixture of the main component material (e.g., 99.9 - 90 wt%) of the treated object 1, i.e., WC or MoC, and the component elements of the diamond sintering reinforcement agent (e.g., 0.1 - 10 wt%), i.e., cobalt (Co), iron (Fe), and nickel (Ni). The second intermediate layer 25 is composed of a mixture of the component elements (e.g., 0.1 - 10 wt%) of the diamond sintering reinforcement agent, i.e., cobalt (Co), iron (Fe), and nickel (Ni), and diamond (e.g., 99.9 - 90 wt%). The diamond film 22 is grown on the second intermediate layer 25.

Furthermore, according to a preferred embodiment of the present invention, there are three intermediate layers i.e (i) a first intermediate layer composed of (a) a component element (e.g., 99.9 - 90 wt%) of the object and (b) a component element (e.g., 0.1 - 10 wt%) of a sintering reinforcement agent for diamond, (ii) a second intermediate layer composed of a mixture of the materials of the first intermediate layer and (c) diamond (e.g., (b): 0.1 - 10 wt%, (a) + (c): 99.9 - 90 wt%, (a)/(c) = 10/90 - 90/10), and (iii) a third intermediate layer composed of (b) a component element (e.g., 0.1 - 10 wt%) of the sintering reinforcement agent and (c) diamond (e.g., 99.9 - 90 wt%).

The present invention, by providing at least two intermediate layers in this way, and gradually changing the composition of the treated object 21 and the diamond film 22, forms a diamond film 22 free from peeling even when formed to a thickness of about 100 µm.

Although there are no critical limitations to the thickness of the intermediate layers and the diamond film, the preferable thickness of each intermediate layer is 2 to 10 µm, more preferably 4 to 8 µm and the preferable thickness of the diamond film is 10 to 100 µm, more preferably 20 to 40 µm. Furthermore, the size of the powder is preferably 0.1 to 8 µm, more preferably 0.4 to 1 µm.

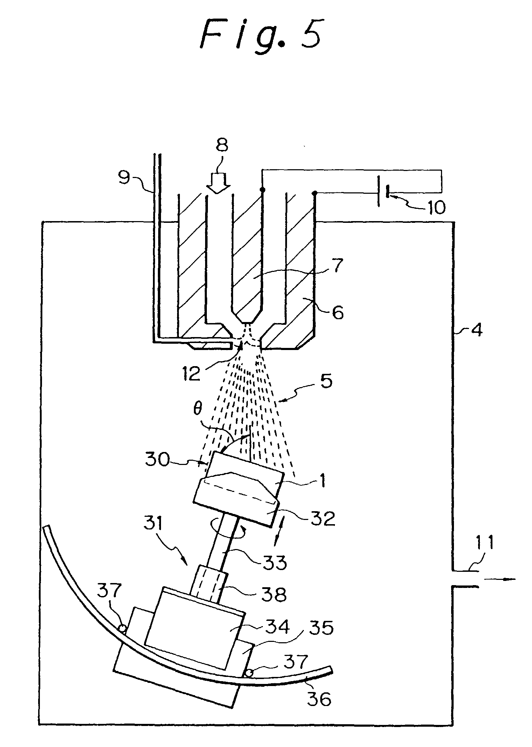

In an embodiment of the present invention, the diamond film is uniformly and firmly deposited on an object or substrate even on the side surfaces thereof as shown in Figs. 5 to 7.

That is, when the above-mentioned intermediate layers and diamond films are to be formed on the object (or substrate) 1, the desired layers and diamond film are not deposited on the side faces 30 of the object, because the plasma jet 5 does not sufficiently impinge on the side surfaces 30 of the object 1. However, according to this embodiment, during the formation of the intermediate layers and the diamond film, the object 1 is rotated and is inclined from the flow direction line of the plasma jet 5 by 30 to 60 degree (see θ in Fig. 5), whereby the intermediate layers and the diamond film are uniformly and firmly deposited on the side faces 30 of the object 1.

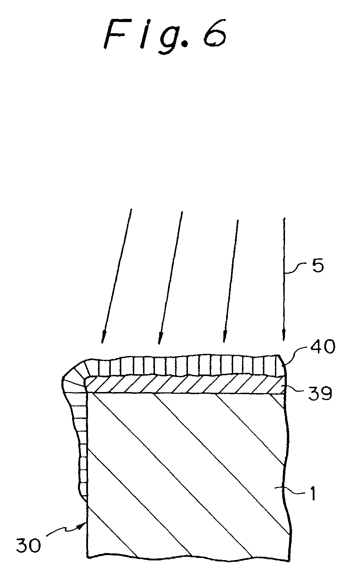

For example, if it is desired to deposit the intermediate layers 39 and the diamond film 40 on the side surfaces 30 of the object 1, the side surfaces 30 will ordinarily not be well covered by the intermediate layers 39, because the plasma jet 5 does not arrive at the side surfaces 30. Accordingly, the diamond film 40 is sometimes directly deposited on the side surfaces 39 as shown in Fig. 6. Thus, the diamond film 40 on the side surfaces 30 tends to be easily peeled off or cracks sometimes occur between the intermediate layer 39 and the diamond film 40 especially at the end portions of the object 1.

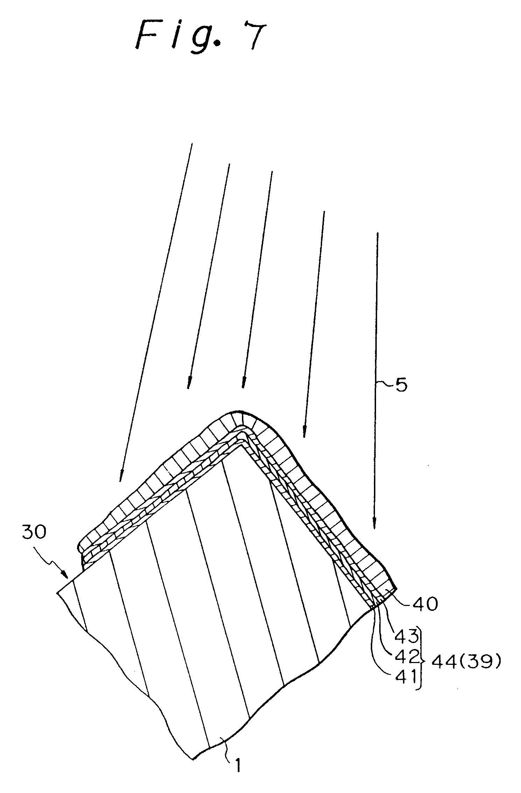

Contrary to the above, since the object 1 is rotated with an angle θ from the flow direction of the plasma jet 5 according to this embodiment, the side faces 30 of the object 1 can be uniformly and firmly covered with the intermediate layers 44 (39) and the diamond film 40, as shown in Fig. 7. In Fig. 7 a first intermediate layer 41 having a thickness of, for example, 2 - 5 µm is formed by introducing a powder from a pipe 9 to a plasma jet 5 formed from hydrogen gas or an inert gas, a second intermediate layer 42 having a thickness of, for example, 10 - 20 µm is formed by introducing a powder from pipe 9 to the plasma jet 5 generated from hydrogen gas and a carbon source, and a third intermediate layer 43 having a thickness of, for example, 20 - 30 µm is formed by introducing a powder from a pipe to a plasma jet 5, generated from hydrogen gas and a carbon source (e.g., hydrocarbon gas such as methane). Thereafter, a diamond film 40 having a thickness of, for example, 30 - 50 µm is formed in the same manner as mentioned above.

The inclination and rotation of the object (or substrate) 1 can be effected in any conventional manner. For example, as shown in Fig. 5, the supporting means 31 of the object (or substrate) 1 is composed of a cooled support 32 for the object 1, a motor 34 provided with a rotating shaft 33 for rotating the support 32, a movable base 35 for carrying the motor 34, and an arc-shaped guide member 36 for moving the movable base 35 so that the surface, to be coated, of the object 1 is inclined at an angle of θ. Although, in the above embodiment, the object 1 is moved so that it is inclined from the plasma jet flow direction, the plasma torch can also be moved in the similar manner.

### EXAMPLE

The present invention will now be explained, in detail, by, but by no means limited to, the following Example.

As the treated object 1, a sintered body using Co as a sintering reinforcement and having a composition of WC-10% Co was used. As the component material of the first intermediate layer 24, WC and Co were used. Further, as the component material of the second intermediate layer 25, diamond and Co were used. As the conditions for growth of the second intermediate layer and diamond film, the CVD apparatus shown in Fig. 3 was used and H₂ gas of 10 to 50 liter/min and CH₄ gas of 0.05 to 1 liter/min were supplied. Further, an arc current of 10 to 70 A and an arc voltage changed in a range of 50 to 150 V were used. The vacuum of the reaction chamber was held in the range of 1 to 10 kPa.

When growing the first intermediate layer on the treated object, H₂ gas was supplied as the starting gas and a plasma jet generated, in which state WC and Co of a particle size of 1 to 5 µm were supplied from the powder feed pipe 9 at a rate of 0.01 to 0.1 cc/h and plasmatized to grow a mixture at a thickness of 20 µm.

The material gas was changed to a mixed gas of H₂ and CH₄ and Co powder of a particle size of 1 to 5 µm was supplied from the powder feed pipe 9 to create a plasma jet and form a second intermediate layer comprised of a mixture of diamond and Co at a thickness of 30 µm.

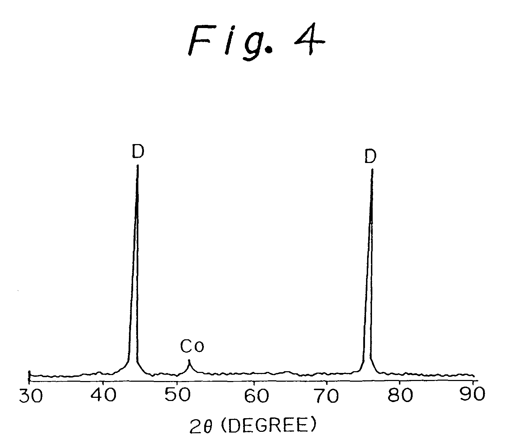

Figure 4 is an X-ray diffraction pattern of the second intermediate layer, where the diffraction lines of diamond (abbreviated as D) and Co appear well, so it is understood that a mixed layer is grown. Then, a plasma jet is created using a mixed gas of H₂ and CH₄ as a material gas and a diamond film of a thickness of about 100 µm is formed on the top. The adhesiveness with the treated object of the diamond film formed in this way is strong. A tensile test gave a value of more than 600 kg/mm².

## Claims

1. A method of producing a diamond film on an object to be treated or a substrate by a chemical vapor deposition method comprising the steps of:
(i) forming a first intermediate layer, on the object to be treated or substrate, composed of a mixture of a main component element of the object or substrate and a component element of a sintering reinforcement agent for diamond selected from the group consisting of cobalt, iron and nickel;
(ii) forming a second intermediate layer, on the first intermediate layer, composed of a mixture of the component element of the sintering reinforcement agent for diamond and diamond; and
(iii) forming a diamond film on the second intermediate layer, all in the same apparatus, which comprises:
(a) an electrode forming member having a first polarity comprising an enclosed body having a nozzle for jetting thermal plasma opened therein and a discharge gas feed pipe;
(b) an electrode forming member having an opposite polarity and positioned to be opposed to said nozzle internally of said enclosed body;
(c) a direct current plasma torch having a power source supply system containing a direct current source for applying a direct current voltage between said electrode of the first polarity and said electrode of the opposite polarity, which feeds a gas through said discharge gas feed pipe between the electrodes to which the direct current voltage is applied, forming said gas into a thermal plasma by the direct current arc discharge between the electrodes and jetting the thermal plasma formed as a plasma jet through said nozzle;
(d) a starting gas feeding system for feeding gaseous starting compounds for vapor phase deposition to said plasma jet;
(e) a powder supplying pipe for feeding a metal powder to said arc discharge portion; and
(f) a supporting mechanism for supporting the object or substrate in the above non-equilibrium plasma and permitting a thermal plasma chemical vapor deposition film to be deposited in a vapor phase on said object or substrate.

2. A method as claimed in claim 1, wherein the diamond film is formed by a method comprising the steps of:
effecting an arc discharge while feeding a starting gas containing hydrogen and a carbon source between an anode and a cathode of a thermal plasma chemical vapor deposition device;
radicalizing a gaseous carbon compound by feeding the gaseous compound to a generated plasma jet, in which the hydrogen molecules are substantially dissociated into hydrogen atoms; and
permitting said radicalized plasma jet to impinge on the object or substrate, to thereby form a film of diamond on the object or substrate.

3. A method as claimed in claim 1 or 2, wherein the first intermediate layer is formed by a method comprising, while effecting the formation of a plasma jet of an inert gas or hydrogen gas, feeding a powder of the main component element of the object or substrate and a powder of the component element of the sintering reinforcement agent to the plasma jet, whereby the powders are melted and the molten elements are deposited on the object or substrate.

4. A method as claimed in claim 1, 2 or 3, wherein the second intermediate layer is formed by a method comprising, while effecting the formation of a plasma jet of hydrogen gas and a carbon source, feeding a powder of the sintering reinforcement agent to the plasma jet.

5. A method as claimed in claim 1, 2, 3 or 4, wherein a third intermediate layer composed of a main component element of the object, a component element of the sintering reinforcement agent and diamond is formed between the first and second intermediate layers.

6. A method as claimed in any preceding claim, wherein the third intermediate layer is formed by a method comprising, while effecting the formation of a plasma jet of hydrogen gas and a carbon source, feeding a powder of the main component element of the object or substrate and a powder of the component element of the sintering reinforcement agent to the plasma jet.

7. A method as claimed in any preceding claim, wherein the object or substrate is inclined at an angle of 30 to 60 degrees from the flow direction of the plasma jet and rotated whereby the diamond film is firmly deposited on the side faces of the object or substrate.

## Patentansprüche

1. Verfahren zur Herstellung eines Diamantfilms auf einem zu behandelnden Gegenstand oder einem Substrat mit Hilfe eines chemischen Dampfniederschlagsverfahrens mit den folgenden Schritten:
(i) Ausbilden einer ersten Zwischenschicht auf dem zu behandelnden Gegenstand oder Substrat, die zusammengesetzt ist aus einer Mischung aus einer Hauptelementkomponente des Gegenstandes oder Substrats und einer Elementkomponente eines Sinterungsverstärkungsagens für Diamant, ausgewählt aus der Gruppe bestehend aus Kobalt, Eisen und Nickel;
(ii) Ausbilden einer zweiten Zwischenschicht auf der ersten Zwischenschicht, die zusammengesetzt ist aus einer Mischung aus der Elementkomponente des Sinterungsverstärkungsagens für Diamant und Diamant; und
(iii) Ausbilden eines Diamantfilms auf der zweiten Zwischenschicht, wobei alle Schritte in der gleichen Vorrichtung ausgeführt werden, die aufweist:
(a) ein elektrodenbildendes Teil mit einer ersten Polarität, das einen umschlossenen Körper aufweist mit einer Düse, um ein thermisches Plasma durch die in den umschlossenen Körper mündende Düse einzustrahlen, und ein Entladungsgaszuführleitung;
(b) ein elektrodenbildendes Teil mit einer entgegengesetzten Polarität, welches in Gegenüberlage zu der Düse positioniert innerhalb des umschlossenen Körpers positioniert ist;
(c) eine Gleichstrom-Plasmafackel mit einem Stromquellenversorgungssystem, welches eine Gleichstromquelle enthält, um eine Gleichspannung zwischen der Elektrode mit der ersten Polarität und der Elektrode mit der entgegengesetzten Polarität anzulegen, wobei ein Gas durch die Entladungsgaszuführleitung zwischen die Elektroden, an die die Gleichspannung angelegt ist, zuführbar ist und wobei das Gas in ein thermisches Plasma durch eine Gleichstromlichtbogenentladung zwischen den Elektroden umgewandelt wird und das als ein Plasmastrahl ausgebildete thermische Plasma durch die genannte Düse eingestrahlt wird;
(d) ein Anlaßgaszuführsystem zum Zuführen von gasförmigen Anlaßzusammensetzungen, um in Verbindung mit dem Plasmastrahl eine Dampfphasen-Niederschlagung zu bewirken;
(e) eine Pulverzuführleitung, um Metallpulver dem Lichtbogenentladungsabschnitt zuzuleiten; und
(f) einen Halterungsmechanismus zur Halterung des Gegenstandes oder des Substrats in dem oben genannten unabgeglichenen Plasma und um das Niederschlagen eines chemischen Dampfphasenniederschlagsfilms gemäß dem thermischen Plasma in einer Dampfphase auf den Gegenstand oder das Substrat zu ermöglichen.

2. Verfahren nach Anspruch 1, bei dem der Diamantfilm durch ein Verfahren ausgebildet wird, welches die folgenden Schritte umfaßt:
Bewirken einer Lichtbogenentladung bei Zuführung eines Anlaßgases, welches Wasserstoff und eine Kohlenstoffquelle enthält, zwischen eine Anode und eine Kathode einer thermoplasma-chemischen Dampfniederschlagsvorrichtung;
Radikalisieren einer gasförmigen Kohlenstoffmischung durch Zuführen der gasförmigen Mischung in einen erzeugten Plasmastrahl, in welchem die Wasserstoffmoleküle im wesentlichen in Wasserstoffatome zerlegt werden; und
den radikalisierten Plasmastrahl auf den Gegenstand oder das Substrat auftreffen lassen, um dadurch einen Film aus Diamant auf dem Gegenstand oder Substrat auszubilden.

3. Verfahren nach Anspruch 1 oder 2, bei dem die erste Zwischenschicht mit Hilfe eines Verfahrens ausgebildet wird, welches darin besteht, daß während der Bewirkung der Bildung eines Plasmastrahls eines inerten Gases oder Wasserstoffgases, ein Pulver der Hauptelementkomponente des Gegenstandes oder Substrats und ein Pulver der Elementkomponente eines Sinterungsverstärkungsagens in den Plasmastrahl zugeführt wird, wodurch die Pulver geschmolzen werden und die geschmolzenen Elemente auf dem Gegenstand oder Substrat niedergeschlagen werden.

4. Verfahren nach Anspruch 1, 2 oder 3, bei dem die zweite Zwischenschicht durch ein Verfahren ausgebildet wird, welches darin besteht, daß bei Bewirken der Ausbildung eines Plasmastrahls des Wasserstoffgases und einer Kohlenstoffquelle, ein Pulver eines Sinterungsverstärkungsagens dem Plasmastrahl zugeführt wird.

5. Verfahren nach Anspruch 1, 2, 3 oder 4, bei dem eine dritte Zwischenschicht, zusammengesetzt aus einer Hauptelementkomponente des Gegenstandes, einer Elementkomponente des Sinterungsverstärkungsagens und Diamant zwischen der ersten und der zweiten Zwischenschicht ausgebildet wird.

6. Verfahren nach irgendeinem der vorhergehenden Ansprüche, bei dem die dritte zwischenschicht durch ein Verfahren hergestellt wird, welches darin besteht, daß während der Bewirkung der Ausbildung eines Plasmastrahls des Wasserstoffgases und einer Kohlenstoffquelle Pulver der Hauptelementkomponente des Gegenstandes oder Substrats und ein Pulver der Elementkomponente des Sinterungsverstärkungsagens dem Plasmastrahl zugeführt werden.

7. Verfahren nach irgendeinem der vorhergehenden Ansprüche, bei dem der Gegenstand oder das Substrat in einem Winkel von 30 bis 60 Grad von der Strömungsrichtung des Plasmastrahls geneigt angeordnet wird und in Drehung versetzt wird, wodurch der Diamantfilm fest auf den Seitenflächen des Gegenstandes oder Substrats niedergeschlagen wird.

## Revendications

1. Procédé pour produire un film de diamant sur un objet à traiter ou sur un substrat, par une méthode de dépôt de vapeur chimique, le procédé comprenant les étapes consistant à :
(i) former une première couche intermédiaire, sur l'objet à traiter ou sur le substrat, composée d'un mélange d'un élément de constituant principal de l'objet ou du substrat et d'un élément de constituant choisi parmi l'ensemble consistant en du cobalt, du fer et du nickel, d'un agent de renforcement de frittage du diament,
(ii) former, sur la première couche intermédiaire, une seconde couche intermédiaire composée d'un mélange de l'élément de constituant de l'agent de renforcement de frittage du diamant ; et de diamant
(ii) former un film de diamant sur la seconde couche intermédiaire, le tout dans le même appareil qui comprend :
(a) un organe formant électrode et ayant une première polarité, comprenant un corps enfermé ayant une buse pour projeter un jet de plasma thermique et un tube d'alimentation en gaz de décharge ;
(b) un organe formateur d'électrode, ayant une polarité opposée et placé de façon à être opposé à ladite buse située à l'intérieur dudit corps fermé ;
(c) une torche à plasma à courant continu, ayant un système d'alimentation en source d'énergie contenant une source de courant continu, pour appliquer une tension de courant continu entre ladite électrode ayant la première polarité et ladite électrode ayant la polarité opposée, qui introduit un gaz dans la totalité du tube d'alimentation en gaz de décharge entre l'électrode à laquelle la tension de courant continu est appliquée, en mettant ledit gaz sous forme d'un plasma thermique par la décharge d'un arc à courant continu entre les électrodes et projetant par ladite buse le plasma thermique mis sous forme d'un jet de plasma ;
(d) un système d'alimentation en gaz de départ pour introduire des composés gazeux de départ pour le dépôt en phase vaperu dans ledit jet de plasma ;
(e) un tube d'alimentation en poudre pour introduire de la poudre de métal dans ladite partie de décharge en arc ; et
(f) un mécansime pour supporter l'objet ou le substrat dans le plasma non équilibré ci-dessus et permettre le dépôt, en phase vapeur sur ledit objet ou ledit substrat, d'un film pour dépôt de vapeur chimique à l'aide d'un plasma thermique.

2. Procédé tel que revendiqué à la revendication 1, dans lequel le film de diamant est formé par un procédé comprenant les étapes consistant à :
effectuer une décharge en arc tout en introduisant du gaz, contenant de l'hydrogène et une source de carbone, entre une anode et une cathode d'un dispositif pour dépôt chimique de vapeur à l'aide d'un plasma thermique ;
former des radicaux d'un composé carboné gazeux en introduisant le composé gazeux dans un jet du plasma engendré, dans lequel les molécules d'hydrogène se dissocient essentiellement en des atomes d'hydrogène ; et
permettre au jet le plasma comportant ainsi des radicaux de heurter l'objet ou le substrat de façon à former un film de diamant sur l'objet ou le substrat.

3. Procédé tel que revendiqué à la revendication 1 ou 2, dans lequel la première couche intermédiaire est formée par un procédé comprenant, tout en effectuant la formation d'un jet de plasma d'un gaz inerte ou d'hydrogène gazeux, l'introduction dans le jet de plasma d'une poudre de l'élément du constituant principal de l'objet ou du substrat et d'une poudre de l'élément de constituant de l'agent de renforcement de frittage, de façon à faire fondre les poudres et à provoquer le dépôt des éléments fondus sur l'objet ou sur le substrat.

4. Procédé tel que revendiqué à la revendication 1, 2 ou 3, dans lequel la seconde couche intermédiaire est formée par un procédé comprenant, tout en effectuant la formation d'un jet de plasma hydrogène gazeux et d'une source de carbone, l'introduction d'une poudre de l'agent de renforcement de frittage dans le jet de plasma.

5. Procédé tel que revendiqué à la revendication 1, 2, 3 ou 4, dans lequel une troisième couche intermédiaire, composée d'un élément de constituant principal de l'objet, d'un élément de constituant de l'agent de renforcement de frittage et de diamant, est formée entre les première et seconde couches intermédiaires.

6. Procédé tel que revendiqué dans l'une quelconque des revendications précédentes, dans lequel la troisième couche intermédiaire est formée par un procédé comprenant, tout en effectuant la formation d'un jet de plasma d'hydrogène gazeux et d'une source de carbone, l'introduction d'une poudre de l'élément de constituant principal de l'objet ou du substrat et d'une poudre de l'élément de constituant de l'agent de renforcement de frittage, dans un jet de plasma.

7. Procédé tel que revendiqué dans l'une quelconque des revendications précédentes, dans lequel l'objet ou le substrat est incliné d'un angle de 30 à 60°, par rapport à la direction d'écoulement du jet de plasma et est mis en rotation, de façon à provoquer le dépôt ferme du film de diamant sur les faces latérales de l'objet ou du substrat.
